(19) Europäisches Patentamt
European Patent Office
Office européen des brevets

(11) EP 1 055 708 A1

(12) **EUROPEAN PATENT APPLICATION**
published in accordance with Art. 158(3) EPC

(43) Date of publication:
**29.11.2000 Bulletin 2000/48**

(21) Application number: **99903902.7**

(22) Date of filing: **09.02.1999**

(51) Int. Cl.$^7$: **C08L 79/08**, C08L 27/18, C08K 3/36

(86) International application number:
**PCT/JP99/00544**

(87) International publication number:
**WO 99/41314 (19.08.1999 Gazette 1999/33)**

(84) Designated Contracting States:
**DE FR GB IT SE**

(30) Priority: **10.02.1998 JP 4296898**

(71) Applicants:
- **Cosmo Research Institute Tokyo 108-8564 (JP)**
- **COSMO OIL CO., LTD Tokyo 105-0023 (JP)**

(72) Inventors:
- **MIZOGUCHI, Takashi, Cosmo Res. Institute Satte-shi, Saitama 340-0193 (JP)**
- **IWAFUNE, Masatoshi, Cosmo Res. Institute Satte-shi, Saitama 340-0193 (JP)**
- **INOUE, Tsuyoshi, Cosmo Res. Institute Satte-shi, Saitama 340-0193 (JP)**
- **KANEKO, Hiroaki, Cosmo Res. Institute Satte-shi, Saitama 340-0193 (JP)**

(74) Representative:
**Hucker, Charlotte Jane**
**Gill Jennings & Every**
**Broadgate House,**
**7 Eldon Street**
**London EC2M 7LH (GB)**

(54) **RESIN COMPOSITION, MOLDED ARTICLE THEREOF, AND PROCESS FOR PRODUCING RESIN COMPOSITION**

(57) A resin composition obtained by mixing 4-52 mass% of fluororesin particles with an average particle diameter of 0.01-300 µm and 48-96 mass% of polyether imide exhibits excellent flowability when thermally plasticized, is molded by injection molding, and can provide molded articles with excellent electrical characteristics, heat resistance, and plating characteristics.

The resin composition can be prepared by a process comprising: dissolving the polyether imide in chloroform to a concentration of 10-500 g/L, dispersing the fluororesin particles in the resulting solution in an amount so that the ratio of the polyether imide and the fluororesin particles is in the range from 15:85 to 85:15 mass%, evaporating the solvent to obtain a preliminary mixture with an average particle diameter of 0.1-500 µm, further adding the polyether imide, and blending the mixture.

EP 1 055 708 A1

## Description

### TECHNOLOGICAL FIELD

The present invention relates to a resin composition exhibiting excellent flowability when thermally plasticized, being molded by injection molding, and capable of providing molded articles with excellent electrical characteristics, heat resistance, and plating characteristics; to the molded articles of the resin composition; and to a process for producing the resin composition.

More particularly, the present invention relates to a resin composition useful for forming electronic parts with a three-dimensional configuration which are molded by injection molding, particularly surface mount parts used in the high frequency region, for example, three-dimensional circuit parts, three-dimensional circuit boards, injection molded interconnection devices (MID), and injection molded circuit boards (MCB); to the molded articles; and to a process for producing the resin composition.

### BACKGROUND TECHNOLOGY

Recently, high speed transmission of signals (i.e. an increase in the amount of information transmitted in a unit period of time or shortening of the transmission time) is demanded in the electronic information field. The use of high frequency transmission signals has been advanced to meet this demand. Because the amount of information transmitted in a unit period of time increases in proportion to the frequency of signals, the use of high frequency transmission signals results in an increase in the transmission speed of signals.

The use of high frequency transmission signals, however, increases signal energy loss (transmission loss), which consequently interferes with high speed transmission of signals. The signal energy loss (transmission loss) is generally called a dielectric loss which is expressed by a function of a frequency, a relative dielectric constant, and a dielectric loss tangent of an insulator (formula (1)).

$$A = k\frac{1}{c}f \cdot \sqrt{\varepsilon_r} \cdot \tan\delta \qquad (1)$$

A: Dielectric loss (dB/cm)
c : Light velocity
f: Frequency (Hz)
k: Constant
$\varepsilon r$: Relative dielectric constant
tan $\delta$: Dielectric loss tangent

As shown in the formula (1), a dielectric loss increases in proportion to the frequency, as well as in proportion to the relative dielectric constant and dielectric loss tangent of an insulator. Therefore, to increase frequency of transmission signals and decrease the dielectric loss at the same time, an insulating material having a low relative dielectric constant and a low dielectric loss tangent must be used.

In particular, recent advances in the utilization of ultrahigh frequency signals such as microwaves and milliwaves have increased the demand for insulating materials with excellent electric characteristics such as a low relative dielectric constant and a low dielectric loss tangent.

More recently, attention has been given to a surface mounting technology which can connect a plurality of electronic devices, such as ICs and LSIs, and interconnect lines on a resin substrate using a solder. A decrease in the fabrication time, simplification of the fabrication process, and decrease in the production cost can be achieved by using the surface mounting technology, because a plurality of electronic devices can be interconnected at one time by heating resin substrates and resin parts to a temperature higher than the melting point of the solder used. Therefore, superior heat resistance at temperatures higher than the melting point of the solders used is demanded for the resins used in the surface mounting technology.

A conventional through-hole mounting technology requires securing each electronic device individually using through-holes in the substrate, whereas the surface mounting technology allows a plurality of electronic devices to be mounted together first by temporarily securing these electronic devices using a cream solder and then by heating the entire substrate to a temperature above the melting point of the solder. Thus, the surface mounting technology requires a resin with excellent heat resistance which can resist temperatures above the melting point of the solder.

In addition, reduction of size and integration of three-dimensional circuits and substrates (MID and MCB) can be achieved by manufacturing these circuits and substrates by injection molding from a thermoplastic resin using

the surface mounting technology. This makes it possible to decrease not only the number of steps in the fabrication process, but also the number of parts. Among the methods for forming electrodes and interconnect lines on three-dimensional circuits and substrates, an electroless plating method is most economical and ensures highest precision.

Therefore, a thermoplastic resin exhibiting excellent plating characteristics (producing plating films with great adhesion strength) is required for fabricating three-dimensional circuits and substrates.

Resin compositions used in the electronic information field thus must be multi-functional. Specifically, these compositions must possess excellent heat resistance, plating characteristics, and electric characteristics. However, commercially available resins and resin compositions having high heat resistance usable for surface mounting which are typified by super engineering plastics have a high relative dielectric constant and high dielectric loss tangent due to inclusion of high polarity bonds such as an ester bond, amide bond, ketone bond, and imide bond, in the main chain of the polymer molecules. There are no resins and resin compositions which satisfy all of the above-mentioned characteristics at the same time.

Japanese Patent Application Laid-open No. 230276/1993, for example, disclose a resin composition exhibiting superior heat resistance and plating characteristics. The resin composition, however, does not necessarily have satisfactory electric characteristics. Specifically, the invention described in this patent application relates to a method of plating molded products of a resin with high resistance. The method comprises applying a plated resin composition containing a resin with a reactive group and calcium carbonate, curing the resin composition, and plating the cured resin. This resin composition does not necessarily have satisfactory electric characteristics due to the use of calcium carbonate. In addition, additional steps of applying and curing the resin composition render the process uneconomical.

The present invention has been achieved in view of this situation and has an objective of providing a resin composition exhibiting excellent flowability when thermally plasticized, being molded by injection molding, and capable of providing molded articles with excellent electric characteristics, heat resistance, and plating characteristics; to the molded articles of the resin composition; and to a process for producing the resin composition.

More specifically, the present invention provides a multi functional resin composition which is useful as a substrate material, structural material, and insulating material for electronic parts, particularly, a material suitably used for the fabrication of three-dimensional electronic parts, inter alia, surface mount parts used in the high frequency region, for example, three-dimensional circuit parts, three-dimensional circuit boards, injection molded interconnection devices (MID), and injection molded circuit boards (MCB); the molded articles; and a process for producing the resin composition.

DISCLOSURE OF THE INVENTION

As a result of extensive studies to achieve the above objective, the present inventors have found that a composition comprising specific fluororesin particles and polyether imide in a specified ratio exhibits excellent flowability when thermally plasticized, can be molded by injection molding, and is capable of providing molded articles with excellent heat resistance, electric characteristics, and plating characteristics. This finding has led to the completion of the present invention.

Specifically, the present invention provides the following resin composition, molded articles produced from the resin composition, and a process for producing the resin composition.

(1) A resin composition obtained by mixing 4-52 mass% of fluororesin particles with an average particle diameter of 0.01-300 μm and 48-96 mass% of polyether imide shown by the following formula (2).

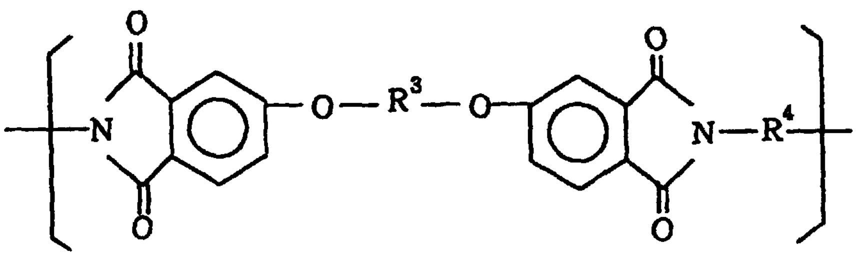

(2)

(2) The resin composition described in (1) above, wherein the operation of mixing the fluororesin particles and the polyether imide comprises preliminary mixing of the fluororesin particles and a portion of the polyether imide and mixing the resulting preliminary mixture and the remaining portion of the polyether imide.

(3) The resin composition described in (2) above, wherein the preliminary mixture comprises 15-85 mass% of the polyether imide and 85-15 mass% of fluororesin particles.

(4) The resin composition described in (2) or (3) above, wherein the preliminary mixture has an average particle diameter of 0.1-500 µm.

(5) The resin composition described in any one of (1) to (4) above, obtained by further mixing silica having an $SiO_2$ structure, a purity of 96% or more, a spherical or amorphous configuration with a particle shape of an aspect ratio of 10 or less, and an average particle diameter of 0.1-100 µm, in an amount of 5-70 mass% for 100 mass% of the fluororesin particles, polyether imide and silica.

(6) A resin composition comprising 4-52 mass% of fluororesin particles with an average particle diameter 0.01-300 µm, 48-96 mass% of polyether imide shown by the following formula (2), and 5-70 mass% (for 100 mass% of the fluororesin particles , polyether imide and silica) of silica having an $SiO_2$ structure, a purity of 96% or more, a spherical or amorphous configuration with a particle shape of an aspect ratio of 10 or less, and an average particle diameter of 0.1-100 µm.

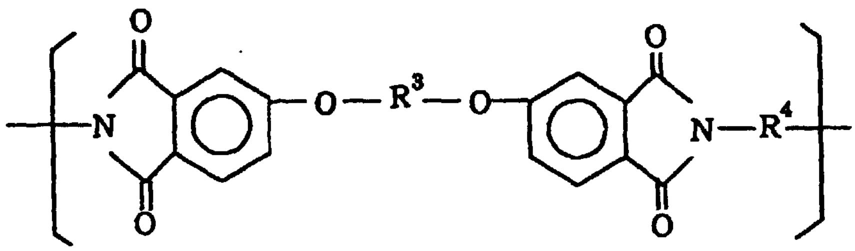

( 2 )

(7) The resin composition described in (6) above, obtained by preliminary mixing of the fluororesin particles and silica, and then mixing the resulting preliminary mixture and the polyether imide.

(8) The resin composition described in any one of (1)-(7) above, wherein the polyether imide has the following formula (3).

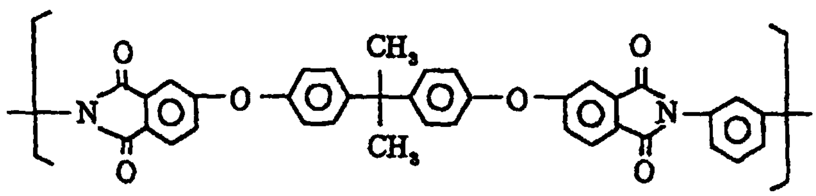

( 3 )

(9) The resin composition described in any one of (1)-(8) above, wherein the polyether imide having the formula (2) or (3) has a number average molecular weight of 3,000-5,000,000.

(10) The resin composition described in any one of (1)-(9) above, which can be formed into a molded article having a relative dielectric constant of 3.5 or less and a dielectric loss tangent of 0.01 or less in a high frequency region of 1 GHz or more.

(11) A molded article obtained by forming the resin composition described in any one of (1)-(10) above.

(12) The molded article described in (11) above, having a relative dielectric constant of 3.5 or less and a dielectric loss tangent of 0.01 or less in a high frequency region of 1 GHz or more.

(13) A process for producing the resin composition according to any one of (1)-(10) above comprising: dissolving the polyether imide in chloroform to a concentration of 10-500 g/L, dispersing the fluororesin particles in the resulting solution in an amount so that the ratio of the polyether imide and the fluororesin particles is in the range from 15:85 to 85:15 mass%, evaporating the solvent to obtain a preliminary mixture with an average particle diameter of 0.1-500 µm, further adding the polyether imide, and blending the mixture.

(14) A process for producing the resin composition described in (7) above, comprising: mixing 1 mass% of the polyether imide and 1-10 mass% of the silica under dry conditions at a temperature above the melting point of the resin to obtain a preliminary mixture, and adding the polyether imide to the preliminary mixture, and blending the mixture.

The present invention will now be explained in detail.

I. Resin composition

The resin composition of the present invention comprises 4-52 mass% of fluororesin particles with an average particle diameter 0.01-300 μm and 48-96 mass% of polyether imide in 100 mass% of resin components constituting the resin composition.

1. Fluororesin

Any resins containing bonded fluorine atoms in the molecule can be used as the fluororesin in the present invention without specific limitations. Tetrafluoroethylene-based polymers are given as examples. As tetrafluoroethylene-based polymers, homopolymers of tetrafluoroethylene and copolymers of tetrafluoroethylene and other monomers (such copolymers may be called tetrafluoroethylene copolymers) can be given.

As other monomers used in the tetrafluoroethylene copolymers, fluorine-containing monomers represented by the formula $CF_2{=}CFR^1$ (wherein $R^1$ is selected from the group consisting of a chlorine atom, $-CF_3$, $-CF_2CF_3$, and $OR^2$, wherein $R^2$ is a perfluoroalkyl group having 1-5 carbon atoms) and vinyl compounds which are described later in this specification can be given. Such other monomers may be used either individually or in combination of two or more. When fluorine-containing monomers are used as the other monomers in tetrafluoroethylene copolymers, the content of recurring units derived from tetrafluoroethylene in the copolymer is preferably from 1 to 99 mol%. When the other monomers are not fluorine-containing monomers (i.e. the other monomers are vinyl compounds such as ethylene, propylene, and styrene), the content of recurring units derived from tetrafluoroethylene in the copolymer is preferably from 20 to 99 mol%.

A homopolymer of tetrafluoroethylene, copolymer of tetrafluoroethylene and perfluoropropylene, copolymer of tetrafluoroethylene and perfluoro (methyl vinyl ether), and the like can be given as examples of tetrafluoroethylene copolymers.

One type of fluororesin or a mixture of two or more types of fluororesins may be used.

The fluororesins used in the present invention are particles having an average particle diameter of 0.01-300 μm, and preferably 0.1-200 μm.

The use of fluororesin in the shape of particles can prevent localization of the fluororesin on the surface of the molded articles which may occur when conventional fluororesin pellets are molded. Plating characteristics are unduly impaired, if fluororesin is localized on the surface of molded articles. If the average particle diameter of fluororesin particles is less than 0.01 μm, the fluororesin particles tend to flocculate, hindering homogeneous dispersion of the fluororesin. If the average particle diameter of fluororesin particles is more than 300 μm, the effect obtained by using the particles cannot be achieved. The resultant molded products are no better than those obtained from conventional fluororesin pellets.

2. Polyether imide

The polyether imide used in the present invention is a polymer having the recurring unit shown by the formula (2).

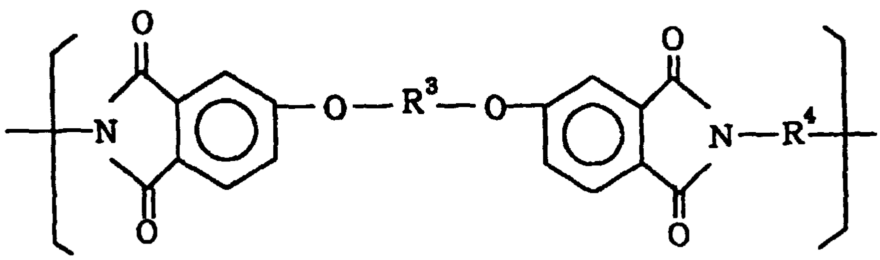

(2)

wherein $R^3$ is a divalent aromatic group having 6-30 carbon atoms, and $R^4$ is a divalent aromatic group having 6-20 carbon atoms, an alkylene group, or a cycloalkylene group.

In the formula (2), $R^3$ is preferably a divalent aromatic group having the structure shown by the following formulas.

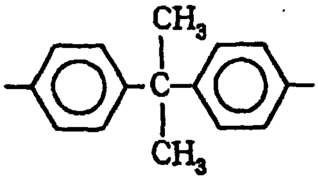, 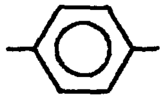, 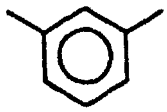

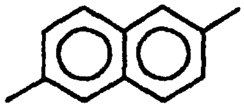, 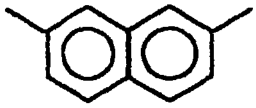, 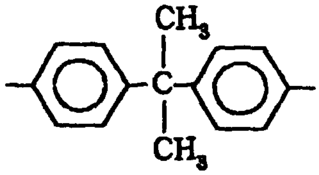

In addition, in the formula (2), $R^4$ is preferably a divalent aromatic group having the following structure.

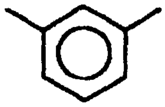, 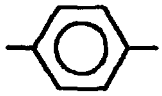, 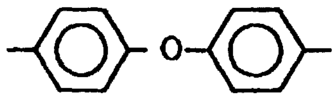

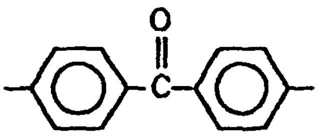, 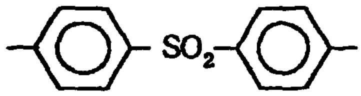

Polyether imide of the structure shown by the formula (3) is the best polymer among the polyether imide of the formula (3).

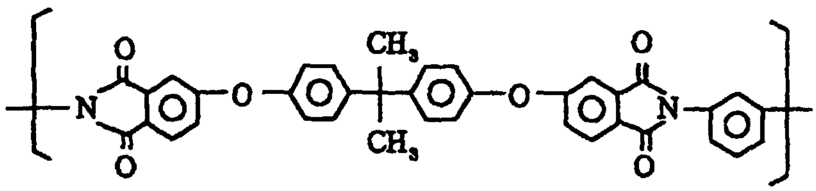 (3)

Although not specifically limited, the number average molecular weight of the polyether imide used in the present invention is preferably in the range from 1,000 to 10,000,000 and more preferably from 3,000 to 5,000,000.

The form of polyether imide is not specifically limited. Either pellets or particles are acceptable.

One type of polyether imide or a mixture of two or more types of polyether imides may be used.

3. Amounts of resin components

As mentioned above, fluororesin particles are contained in the amount of 4-52 mass%, preferably 10-40 mass%, and polyether imide is contained in the amount of 48-96 mass%, preferably 60-90 mass% for 100 mass% of the total of resin components. In addition to the fluororesin particles and polyether imide, resin components such as polyimide, polyester, polyether sulphone, polyphenylene sulfide, liquid crystal polymer, polyolefin, polystyrene, and the like may be used as required.

If the amount of polyether imide in the resin composition is more than 96 mass%, that is, if the amount of

fluororesin particles is less than 4 mass%, both relative dielectric constant and dielectric loss tangent increase due to an increase in the amount of imide bonds in the resin composition and an increase in the water absorption of the resin.

On the other hand, if the amount of polyether imide in the resin composition is less than 48 mass%, that is, if the amount of fluororesin particles is more than 52 mass%, the resulting resin composition exhibits impaired mechanical characteristics. The product is not only unduly fragile, but also exhibits insufficient plating characteristics due to a high content of unstable fluororesin components which are chemically unstable.

4. Silica

The resin composition of the present invention may contain specific silica, if necessary. The specific silica in this invention means silica having the structure of $SiO_2$; a purity of 96% or more, preferably 99% or more; a spherical or amorphous configuration with a particle shape usually of an aspect ratio of 10 or less, preferably 1-10, and more preferably 1-5; and an average particle diameter of 0.1-100 μm, and preferably 1-50 μm.

The amount of silica incorporated is preferably 5-70 mass%, more preferably 10-60 mass%, and most preferably 20-50 mass%, for 100 mass% of the total of fluororesin particles, polyether imide and silica.

The addition of silica ensures further improvement of the electric characteristics (relative dielectric constant, dielectric loss tangent), heat resistance, and plating characteristics.

The aspect ratio in the present invention means the width-to-height ratio of silica particle, i.e. the ratio of the length in the long axis direction to the length in the short axis direction of silica particles.

If the purity of $SiO_2$ is less than 96%, the relative dielectric constant and dielectric loss tangent of the resulting products may be higher than those produced from the resin composition with a higher purity.

If the average particle diameter is less than 0.1 μm or more than 100 μm, the resulting products may exhibit impaired plating characteristics. Specifically, when the average particle diameter is less than 0.1 μm, the size of anchor holes resulting from desorption of silica is so small that it is difficult for a series of electroless plating chemicals (catalysts, etc.) to impregnate deep into the anchor holes. In contrast, if the average particle diameter is more than 100 μm, the size of anchor holes becomes excessively large, resulting in a rough plating film surface which decreases plating adhesion strength.

If the aspect ratio is more than 10, distribution of anchor holes becomes non-homogeneous, resulting in plating films with uneven adhesion strength. The plating adhesion strength is also decreased, because the shape of anchor holes becomes fibrous.

Although any silica manufactured by known processes can be used in the present invention without specific limitations, commonly called molten quartz or silica glass which is industrially manufactured by melting, quenching, and pulverizing crystalline quartz can be preferably used due to the high purity and easy availability.

5. Other components

To provide the resin composition of the present invention with additional characteristics (functions), various additives such as thermal stabilizers, antioxidants, flame retardants, and UV absorbers can be added to the extent that electric characteristics, heat resistance, plating characteristics, and the like which are the features of the present invention are not adversely affected. However, additives such as plasticizers, crosslinking agents, and glossing agents are unnecessary in view of the characteristics required for the resin composition of the present invention. These additives should not be used to avoid the situation where the characteristics of the resin composition of the present invention are impaired.

The use of fluororesin in the form of particles in the resin composition of the present invention ensures sufficient dispersion of the fluororesin in polyether imide. Therefore, mutual solubilizers or dispersants which are commonly used for increasing mutual solubility or dispersibilty are unnecessary in blending the resins in the present invention.

When silica is incorporated in the present invention, the silica may be treated by a conventional surface treating method to improve dispersibility and affinity with resins or to increase the thermal stability and oxidation stability.

Although the above-mentioned specific silica can be used as an organic filler in the resin composition of the present invention, other organic fillers may be added to the extend that the electric characteristics and plating characteristics are not impaired.

For instance, fillers such as aluminum borate, glass, glass staple fibers, glass fibers, potassium titanate, magnesium borate, alumina, alumina fibers, calcium carbonate, magnesium carbonate, magnesium sulfate, calcium sulfate, aluminum sulfate, pyrophosphate, silicon nitride, aluminum nitride, boron nitride, silicon carbide, and molybdenum disulfide can be added for the purposes of improvement of mechanical characteristics and heat resistance, and weight reduction.

Because the above fillers may impair electric characteristics of the resin composition, the amount of addition

should be limited to the range in which the target relative dielectric constant and dielectric loss tangent are maintained.

Although slightly less effective than silica, aluminum borate is a filler suitable for the object of the present invention.

If glass, glass staple fibers, glass fibers, calcium carbonate, magnesium carbonate, magnesium sulfate, calcium sulfate, aluminum sulfate, or pyrophosphate is added only for the purpose of improving mechanical characteristics and heat resistance, these additives may impair electric characteristics although there is no problem in the plating characteristics.

Potassium titanate, magnesium borate, alumina, alumina fibers, and boron nitride may impair not only electric characteristics, but also plating characteristics, if added in such an amount as required.

Furthermore, silicon nitride, aluminum nitride, silicon carbide, and molybdenum disulfide impair plating characteristics and electric characteristics. Preferably, the addition of these additives should be avoided for the purpose of the present invention.

6. Flowability and moldability

Because the resin composition of the present invention has excellent thermal plasticity and flowability, the resin composition exhibits superior moldability. The resin composition can thus be formed into molded articles using various molding methods such as injection molding.

The resin composition of the present invention has a melt flow rate (MFR) measured according to JIS K7210 preferably of 20 or more, and more preferably 30 or more.

II. Molded articles

The molded articles of the present invention can be prepared by molding the above resin composition by various commonly used molding methods such as injection molding, and have excellent electrical characteristics, heat resistance, and plating characteristics.

1. Electrical characteristics

The molded articles of the present invention have electrical characteristics, and exhibit a low relative dielectric constant and a low dielectric loss tangent in high frequency regions, particularly at frequencies above 1 GHz. Here, the lower the relative dielectric constant and dielectric loss tangent, the greater the effect of dielectric loss reduction at high frequencies. The electrical characteristics required for the present invention are a relative dielectric constant of 3.5 or less, preferably 3.3 or less, and a dielectric loss tangent of 0.01 or less, preferably 0.005 or less, both at high frequencies of 1 GHz or more, and preferably 10 GHz or more.

2. Heat resistance

The molded articles of the present invention exhibit heat resistance sufficient for various parts to be surface mounted in the fabrication of ICs and LSIs. Specifically, the molded articles are resistant at temperatures higher than the melting point of solders which are commonly used for surface mounting. The melting point of solders commonly used for surface mounting is 150 to 230°C.

3. Plating characteristics

The molded articles of the present invention exhibits superior plating characteristics. For instance, it is possible to form electroless plating membranes with superior adhesion to the surface of injection molded articles. In the molded articles of the present invention, the plating characteristics can be improved by specifying the particle size of fluororesin particles, thereby increasing dispersibility and reducing localization of fluororesin. These are the other unexpected results achieved by specifying the diameter of the fluororesin particles. Specifically, fluororesin particles are released from the surface of molded articles during chemical etching, allowing micropores to be formed on the surface in the same manner as in the case of causing inorganic fillers to dissolve out. This results in unexpectedly superior plating characteristics.

In general, adhesion strength of plating films in electroless plating is greatly affected by surface wettability for permitting electroless plating catalyst to be adsorbed and an anchoring effect for obtaining physical adhesiveness.

Usually, a metal such as palladium, which has a higher ionization tendency than the metals used for electroless plating such as copper or nickel, is used as a catalyst for electroless plating. To cause palladium, for instance, to be adsorbed onto the surface, palladium ion (an aqueous solution) is applied to the surface and then converted into palladium by reduction. Therefore, if the surface wettability of the electroplated article is low, that is, if the article has high water repellency, the metal ion is adsorbed onto the surface only with difficulty, resulting in difficulty in electroless plating.

To increase the surface wettability of molded articles, it is desirable to form hydrophilic polar groups on the surface by chemical treatment with an acid or alkali aqueous solution.

In addition, to obtain an anchor effect, it is desirable to form homogeneous holes with an appropriate diameter on the the surface of molded articles. Such holes are for anchorage and hereinafter are called "micropores".

In a common method of forming micropores on the surface of resin molded articles, the surface of molded articles formed from a resin composition containing specific inorganic fillers is chemically etched using an acid, an alkali, or an organic solvent.

For example, a specific amount of an inorganic filler which is soluble in an acid, alkali, or organic solvent is added to a resin composition, and the molded articles formed from the resin composition are chemically etched using a solvent (an acid, alkali, or organic solvent) to remove the inorganic filler, whereby micropores are formed on the surface of resin molded articles.

A preferable method of plating used with the molded article of the present invention will now be described.

A plating process typically consists of an etching step for providing the surface of the molded article with wettability by homogeneously forming anchoring holes, and an electroless plating step which comprises causing a catalyst to be adsorbed onto the surface of the molded articles, impregnating the molded articles with an electroless plating solution, and causing plating films to be deposited.

The electroless plating step can be carried out using the same method as applied to plating common resin molded articles. It is possible to perform electric plating after the electroless plating.

Etching of molded articles of the present invention can be carried out preferably by chemical etching using an acid or alkali solution.

Either one acid or alkali solution, or combinations of two or more acid and/or alkali solutions (either alternately or repeatedly) may be used in chemical etching.

Solutions of sulfuric acid, hydrochloric acid, chromic acid, nitric acid, phosphoric acid, or mixtures of these acids can be given as specific examples of acid solutions.

As specific examples of alkali solutions, aqueous solutions of hydroxide of alkali metal or alkaline earth metal, or an ammonia solution are preferable. An aqueous solution of sodium hydroxide, potassium hydroxide, or lithium hydroxide is particularly preferable in view of economy.

Stirring, ultrasonic irradiation, air bubbling, and the like can be employed to perform efficient chemical etching.

III. Process for producing the resin composition

1. Resin composition (not containing silica)

(1) Mixing method

The resin composition of the present invention can be prepared by mixing the above-described fluororesin particles and polyether imide. Various conventional mixing methods for manufacturing resin compositions can be used. Kneading or melt kneading which is a common method of manufacturing composite materials is preferably used. The melt kneading is particularly preferred in industrial scale manufacturing in view of productivity and economy.

Specific melt kneading methods include a method using a continuous kneader using a uniaxial or biaxial extruder and a method using a batch-type heat melt kneader typified by a laboplastmill. The use of a biaxial extruder which excels in economy and kneading efficiency is particularly preferred.

Thorough and homogeneous dispersion of the components for the resin composition of the present invention is preferable for obtaining excellent mechanical characteristics, electric characteristics, and plating characteristics.

For this reason, preferable conditions for manufacturing the resin composition of the present invention are using an extruder with a screw diameter of 20-150 mm and a L/D ratio of 20-50 at a kneading temperature (resin temperature), preferably 320-370°C, and a screw rotation of 50-300 rpm, preferably 80-250 rpm.

If the kneading temperature (resin temperature) is more than 380°C, the fluororesin may thermally decompose and generate toxic gas. If less than 300°C, the viscosity remains too high for the components to be sufficiently dispersed, which may result in impaired mechanical, electrical, and plating characteristics.

In addition, operation at a screw rotation of less than 50 rpm or more than 300 rpm may also render dispersion of the components insufficient and may result in impaired mechanical, electrical, and plating characteristics.

(2) Preliminary mixing

In manufacturing the resin composition of the present invention, it is possible to preliminary mix fluororesin particles with an average diameter of 0.01-300 μm and polyether imide, and then mix the resulting preliminary mixture with polyether imide.

Homogeneous dispersion of fluororesin is important for the present invention to exhibit its effect. Although this is achieved by using fluororesin particles with an average diameter of 0.01-300 μm, a better effect can be obtained by more homogeneous dispersion using a process of preliminary mixing fluororesin and polyether imide, and mixing the resulting preliminary mixture with polyether imide.

The proportion of polyether imide and fluororesin particles in the preliminary mixture is 15-85 mass% of polyether imide and 85-15 mass% of fluororesin particles, preferably 30-70 mass% of polyether imide and 70-30 mass% of fluororesin particles, for 100 mass% of the total resin components.

The preliminary mixture which brings about the intended superior effect of the present invention cannot be obtained if the proportion is outside the above proportion.

Adjusting the particle size of the preliminary mixture further promotes the effect of the present invention. Specifically, more homogeneous aspersion of fluororesin particles is ensured.

The average diameter of the preliminary mixture is preferably 0.1-500 μm, and more preferably 1-400 μm.

Similar to the case where the average diameter of fluororesin particles is less than 0.01 μm, the average diameter less than 0.1 μm may induce flocculation among particles in the preliminary mixture and may rather hinder homogeneous dispersion. If the average diameter is more than 500 μm, on the other hand, it is difficult to obtain a resin composition in which fluororesin particles are homogeneously dispersed.

There are no specific limitations to the method of the preliminary mixing inasmuch as fluororesin particles are coated with polyether imide. One example of such a method comprises dissolving polyether imide in an organic solvent in which fluororesin particles are not dissolved, dispersing fluororesin particles in the solution, and evaporating the solvent.

In a specific preferred example, polyether imide is dissolved in chloroform (in which polyether imide is dissolved at a concentration above 10 g/l at 20°C, but the fluororesin particles with an average diameter of 0.01-300 μm are not dissolved) to make a concentration of 10-500 g/l, the fluororesin particles are dispersed in this solution in a such amount so that the proportion of polyether imide and fluororesin particles is in the range of 15:85 to 85:15 (mass%), and the solvent is evaporated to obtain a preliminary mixture containing particles with an average diameter of 0.1-500 μm. Polyether imide is further added to and mixed with the preliminary mixture thus obtained.

In addition to chloroform, dichloromethane, tetrahydrofuran, dimethylformamide, dimethylacetamide, N-methylpyrrolidone, and the like can be given as the solvent used in this method.

Conditions for the preliminary mixing are as follows.

The temperature is above room temperature and below the boiling point of the solvent. A higher temperature is desirable in view of solubility. A higher pressure is acceptable, but usually atmospheric pressure is sufficient. The mixture is preferably stirred to increase the efficiency of the fluororesin particle dispersion. Stirring is carried out using a mechanical stirrer or a magnetic stirrer, for example.

Given as the method of evaporating the solvent to take the preliminary mixture to dryness and obtain a powdery product are a spray drying method which comprises removing the solvent by atomizing the solution from nozzles of a spray drier into a vacuum container; a pulverizing method which comprises simply evaporating the solution to obtain a bulk of polyether imide and fluororesin particles, and mechanically pulverizing the bulk into powder; a freeze-dry method; and a re-precipitation method which comprises re-precipitating the preliminary mixture using a large amount of a poor solvent (an solvent in which polyether imide is insoluble, such as hexane, methanol, and water).

To obtain a composite powder with a prescribed average diameter, the method of mechanically pulverizing after solvent evaporation or the method of spray drying by evaporation of solvent sprayed into a vacuum vessel is preferred.

As described above, a resin composition exhibiting excellent flowability when thermally plasticized, being molded by injection molding, and capable of providing molded articles with excellent electrical characteristics (low relative dielectric constant and low dielectric loss tangent), heat resistance, and plating characteristics required for surface mounting, as well as molded articles thereof can be provided according to the present invention. In addition, a process which can easily produce the resin composition having the above characteristics (performance) is provided by the present invention.

2. Resin composition (containing silica)

The resin composition (containing silica) of the present invention can be prepared by mixing the above-described fluororesin particles, polyether imide, and silica. Although the process for producing the resin composition not

containing silica described above may be applied to the resin composition, the following special notes apply.

A specific process applied to the manufacture of the resin composition containing silica comprises blending the above fluororesin particles and silica at a temperature below the melting point of the resin to increase dispersibility of the fluororesin particles under dry conditions (dry blending) thereby obtaining a preliminary mixture, then adding polyether imide and mixing the mixture.

Conventionally known methods of blending powders are applicable to the dry blending.

A preferable proportion of silica used for 1 mass% of the fluororesin particles in the preliminary mixing is 1-10 mass%, and more preferably 2-5 mass%.

Mechanical mixing using a V-type mixer, Henschel mixer, or omuni mixer is preferable.

The mixing is carried out preferably below the melting point of the fluororesin, and more preferably from room temperature to 100°C. If the temperature is higher than the melting point, mixing becomes difficult due to melting of the fluororesin; if less than room temperature, the particles may be moistened with condensate.

## BRIEF DESCRIPTION OF THE DRAWINGS

Figure 1 is a flowchart showing an outline of the process for chemically etching the surface of a test specimen.
Figure 2 is a flowchart showing an outline of the process of electroless plating.

## BEST MODE FOR CARRYING OUT THE INVENTION

The present invention will now be described in more detail by way of examples, which should not be construed as limiting the present invention.

(1) Raw materials

The following raw materials were used in Examples and Comparative Examples.

PEI: Polyether imide having the recurring unit of formula (3) ("Ultem 1010-1000" manufactured by Japan GE Plastics Co., Ltd.)

PTFE-1: Polytetrafluoroethylene particles, average particle diameter: 3 μm ("TFW-3000" manufactured by Seishin Kigyo Co., Ltd.)

PTFE-2: Polytetrafluoroethylene particles, average particle diameter: 10 μm ("TFW-1000" manufactured by Seishin Kigyo Co., Ltd.)

PTFE-3: Polytetrafluoroethylene particles, average particle diameter: 200 μm, the product obtained by mechanically pulverizing the molten bulk of "Teflon TFE914J" (manufactured by Mitsui-DuPont Fluorochemical Co., Ltd.)

PTFE-4: Polytetrafluoroethylene (pellets), average pellet size: ϕ 3 mm × 5 mm

PTFE-5: Polytetrafluoroethylene particles, average particle diameter: 330 μm, the product obtained by mechanically pulverizing the molten bulk of "Teflon TFE914J" (manufactured by Mitsui-DuPont Fluorochemical Co., Ltd.)

PTA: Teflon PTA particles, "Teflon MP-10" (manufactured by Mitsui-DuPont Fluorochemical Co., Ltd.), average particle diameter: 30 μm

(2) Preparation of preliminary mixture

Chloroform, which is an organic solvent in which polyether imide (PEI) is dissolved at a concentration of above 10 g/l at 20°C, but the fluororesin is not dissolved, was used. PEI was dissolved in chloroform to make a solution with a concentration of 100 g/l. Polytetrafluoroethylene particles (PTFE-1) were mixed with the solution at a prescribed ratio, dispersed, and the solvent was evaporated to obtain a preliminary mixture. Preliminary mixtures thus prepared are shown in Table 1.

PF-1: Preliminary mixture 1

PEI/PTFE-1 (mass%) = 50/50
PTFE average particle diameter = 3 μm
Composite powder average particle diameter: 10 μm

PF-2: Preliminary mixture 2

PEI/PTFE-1 (mass%) = 50/50
PTFE average particle diameter = 3 µm
Composite powder average particle diameter: 100 µm

PF-3: Preliminary mixture 3

PEI/PTFE-1 (mass%) = 50/50
PTFE average particle diameter = 3 µm
Composite powder average particle diameter: 500 µm

PF-4: Preliminary mixture 4

PEI/PTFE-1 (mass%) = 20/80
PTFE average particle diameter = 3 µm
Composite powder average particle diameter: 100 µm

PF-5: Preliminary mixture 5

PEI/PTFE-1 (mass%) = 80/20
PTFE average particle diameter = 3 µm
Composite powder average particle diameter: 100 µm

Silica: $SiO_2$. high purity silica "Fuselex ZA30" manufactured by Tatsumori Co., Ltd.

Amorphous
Polyether imide purity = 99.9%
Aspect ratio = 1.1
Average particle diameter = 5 µm

(3) Evaluation of properties

〈Evaluation of electrical characteristics〉

* Measurement of relative dielectric constant and dielectric loss tangent

Frequency: 1 GHz, 10 GHz, 20 GHz
Temperature: 25°C
Measuring method: Triplate rail resonance method (loss separation method)
(1 GHz - 25 GHZ)
Reference document: IEEE Trans., I&M., p 509-514 (1989).

〈Evaluation method of plating characteristics〉

* Electroless plating method

The surface of test specimen strips was chemically etched by the method shown in Figure 1 and plated by the electroless plating method shown in Figure 2, to form electroless plating films with a thickness of 10 µm. After electroless plating, the test specimens were annealed for 3 hours in an air-circulating oven at 200°C.
Adhesiveness of the plating films was evaluated according to the following method.

* Swelling of plating films

After electroless plating, the plating films were visually observed to evaluate the presence or absence of swelling according to the following standard.

◎: No swelling was observed at all.
○: Almost no swelling was observed.
△: Swelling was observed in part of plating films.
X: Swelling was observed in the entire surface of plating films.

* Evaluation of plating film adhesion (Cross-cut test)

According to JIS C-5012, the edge of a cutter knife was placed on a plated surface at an angle of 35-45° so that the edge penetrated the plating film, and the cutter knife was drawn at a constant speed of about 0.5 second per line. 11 x 11 orthogonal lines at a space of 1 mm were drawn to produce 100 cross-cut squares in 100 $mm^2$. After removing plating fragments on the surface of test specimens using a soft brush, a transparent adhesive tape with a width of 12mm prescribed in JIS Z-1522 was attached to cover all of the cross-cut squares so that no air bubbles were inserted. After about 10 minutes, the tape was quickly pulled in the vertical direction to peel off from the surface. The number of squares peeled off was counted by visual inspection. The following evaluation standard was applied.

◎: The number of removed squares = 0
○: The number of removed squares = 1-5
△: The number of removed squares = 6-10
X: The number of removed squares = 11 or more

〈Evaluation of heat resistance〉

Test specimen strips plated by the electroless plating method was heated for 30 minutes at 200°C. immediately placed in an oven at 240°C, allowed to stand for one minute, then allowed to cool gradually to room temperature. Distortion, swelling of plating films, and the presence or absence of peeling were visually evaluated. The following evaluation standard was applied.

* Distortion of molded articles

○: No distortion
△: There is slight distortion.
X: There is substantial distortion.

* Swelling of plating films

○: No swelling
△: There is slight swelling.
X: Swelling was observed in the entire surface of plating films.

* Peeling of plating films

◯: No peeling
△: There is slight peeling.
X: Peeling was observed over the entire surface of plating films.

〈Evaluation of flowability〉

The melt flow rate (MFR) was measured according to JIS K7210. This method measures the extrusion speed when a molten thermoplastic resin is extruded through a die with a specified length and diameter under prescribed temperature and pressure conditions. The melt flow rate (MFR) is an extrusion speed which is the amount of the molten resin extruded per 10 minutes. Measuring instrument: Semi-automelt indexer 2A, manufactured by Toyo Seiki Co., Ltd.

Temperature: 340, 350, 360, 370°C
Test load: 5 kgf
External diameter of the die: 9.5 mm
Internal diameter of the die: 2.095 mm
Length of the die: 8 mm

(Example 1)

PEI, PTFE-1, and silica were placed in individual quantitative feeders, and fed to a biaxial kneader ("KTX46" manufactured by Kobe Steel Co., Ltd.) for 20 minutes at a rate of 28.5kg/hour, 1.5 kg/hour, and 20 kg/hour, respectively. The mixture was kneaded at 160 rpm while heating at a barrel setting temperature of 340°C, cooled with water, and extruded from a palletizer while cutting strands to obtain 10 kg of pellets (the material before molding) of the resin composition.
The pellets were dried for three hours in an air circulating oven at 150°C and molded using an injection molding machine ("HB 140" manufactured by Hishiya Steel Manufacturing Co.. Ltd.) to obtain test specimens (125 x 13 x 3.1 mm strips and ϕ100 x 1.6 mm disks) for the evaluation of electrical characteristics, heat resistance, and plating characteristics.
The electrical characteristics, heat resistance, and plating characteristics were evaluated using the resulting test specimens.

(Example 2)

The electrical characteristics, heat resistance, and plating characteristics were evaluated using the test specimens prepared in the same manner as in Example 1, except that the feed rates of PEI and PTFE-1 were changed to 27.0 kg/hour and 3.0 kg/hour, respectively.

(Example 3)

The electrical characteristics, heat resistance, and plating characteristics were evaluated using the test specimens prepared in the same manner as in Example 1, except that the feed rates of PEI and PTFE-1 were changed to 24.0 kg/hour and 6.0 kg/hour, respectively. In addition, the flowability of the resin composition before molding was evaluated.

(Example 4)

The electrical characteristics, heat resistance, and plating characteristics were evaluated using the test specimens prepared in the same manner as in Example 1, except that the feed rates of PEI and PTFE-1 were changed to 21.0 kg/hour and 9.0 kg/hour, respectively. The flowability of the resin composition before molding was also evaluated.

(Example 5)

The electrical characteristics, heat resistance, and plating characteristics were evaluated using the test specimens prepared in the same manner as in Example 1, except that the feed rates of PEI and PTFE-1 were changed to 15.0 kg/hour and 15.0 kg/hour, respectively.

(Example 6)

The electrical characteristics, heat resistance, and plating characteristics were evaluated using the test specimens prepared in the same manner as in Example 1, except that the feed rates of PEI, PTFE-1, and silica were changed to 32.0 kg/hour. 8.0 kg/hour, and 10.0 kg/hour, respectively.

(Example 7)

The electrical characteristics, heat resistance, and plating characteristics were evaluated using the test specimens prepared in the same manner as in Example 1, except that the feed rates of PEI, PTFE-1, and silica were changed to 20.0 kg/hour, 5.0 kg/hour, and 25.0 kg/hour, respectively.

(Example 8)

The electrical characteristics, heat resistance, and plating characteristics were evaluated using the test specimens prepared in the same manner as in Example 1, except that the feed rate of PEI was changed to 24.0 kg/hour, and PTFE-2 was used instead of PTFE-1 at a feed rate of 8.0 kg/hour.

(Example 9)

The electrical characteristics, heat resistance, and plating characteristics were evaluated using the test specimens prepared in the same manner as in Example 1, except that the feed rate of PEI was changed to 24.0 kg/hour, and PTFE-3 was used instead of PTFE-1 at a feed rate of 8.0 kg/hour.

(Example 10)

The electrical characteristics, heat resistance, and plating characteristics were evaluated using the test specimens prepared in the same manner as in Example 1, except that the feed rate of PEI was changed to 24.0 kg/hour, and PFA was used instead of PTFE-1 at a feed rate of 8.0 kg/hour.

(Example 11)

The electrical characteristics, heat resistance, and plating characteristics were evaluated using the test specimens prepared in the same manner as in Example 1, except that the feed rate of PEI was changed to 27.0 kg/hour, and PF-1 was used instead of PTFE-1 at a feed rate of 3.0 kg/hour.

(Example 12)

The electrical characteristics, heat resistance, and plating characteristics were evaluated using the test specimens prepared in the same manner as in Example 1, except that the feed rate of PEI was changed to 24.0 kg/hour, and PF-1 was used instead of PTFE-1 at a feed rate of 6.0 kg/hour. In addition, the flowability of the resin composition before molding was evaluated.

(Example 13)

The electrical characteristics, heat resistance, and plating characteristics were evaluated using the, test specimens prepared in the same manner as in Example 1, except that the feed rate of PEI was changed to 18.0 kg/hour, and PF-1 was used instead of PTFE-1 at a feed rate of 12.0 kg/hour. In addition, the flowability of the resin composition before molding was evaluated.

(Example 14)

The electrical characteristics, heat resistance, and plating characteristics were evaluated using the test specimens prepared in the same manner as in Example 1, except that the feed rate of PEI was changed to 6.0 kg/hour, and PF-1 was used instead of PTFE-1 at a feed rate of 24.0 kg/hour. In addition, the flowability of the resin composition before molding was evaluated.

(Example 15)

The electrical characteristics, heat resistance, and plating characteristics were evaluated using the test specimens prepared in the same manner as in Example 1, except that the feed rate of PEI was changed to 24.0 kg/hour, and PF-1 was used instead of PTFE-1 at a feed rate of 16.0 kg/hour, and silica was charged at a rate of 10.0 kg/hour.

(Example 16)

The electrical characteristics, heat resistance, and plating characteristics were evaluated using the test specimens prepared in the same manner as in Example 1, except that the feed rate of PEI was changed to 12.0 kg/hour, and PF-1 was used instead of PTFE-1 at a feed rate of 8.0 kg/hour, and silica was charged at a rate of 30.0 kg/hour.

(Example 17)

The electrical characteristics, heat resistance, and plating characteristics were evaluated using the test specimens prepared in the same manner as in Example 1, except that the feed rate of PEI was changed to 18.0 kg/hour, and PF-2 was used instead of PTFE-1 at a feed rate of 12.0 kg/hour, and silica was charged at a rate of 20.0 kg/hour.

(Example 18)

The electrical characteristics, heat resistance, and plating characteristics were evaluated using the test specimens prepared in the same manner as in Example 1, except that the feed rate of PEI was changed to 18.0 kg/hour, and PF-3 was used instead of PTFE-1 at a feed rate of 12.0 kg/hour, and silica was charged at a rate of 20.0 kg/hour.

(Example 19)

The electrical characteristics, heat resistance, and plating characteristics were evaluated using the test specimens prepared in the same manner as in Example 1, except that the feed rate of PEI was changed to 18.0 kg/hour, and PF-4 was used instead of PTFE-1 at a feed rate of 12.0 kg/hour, and silica was charged at a rate of 20.0 kg/hour.

(Example 20)

The electrical characteristics, heat resistance, and plating characteristics were evaluated using the test specimens prepared in the same manner as in Example 1, except that the feed rate of PEI was changed to 18.0 kg/hour, and PF-5 was used instead of PTFE-1 at a feed rate of 12.0 kg/hour, and silica was charged at a rate of 20.0 kg/hour.

(Example 21)

PEI and PTFE-1 were placed in individual quantitative feeders, and fed to a biaxial kneader ("KTX46" manufactured by Kobe Steel Co., Ltd.) for 20 minutes at a rate of 47.5 kg/hour and 2.5 kg/hour, respectively. The mixture was kneaded at 160 rpm while heating at a barrel setting temperature of 340°C, cooled with water, and extruded from a palletizer while cutting strands to obtain 10 kg of pellets (the material before molding) of the resin composition.

The pellets were dried for three hours in an air circulating oven at 150°C and molded using an injection molding machine ("HB 140" manufactured by Hishiya Steel Manufacturing Co., Ltd.) to obtain test specimens (125 x 13 x 3.1 mm strips and ϕ100 x 1.6 mm disks) for the evaluation of electrical characteristics, heat resistance, and plating characteristics.

The electrical characteristics, heat resistance, and plating characteristics were evaluated using the resulting test specimens.

(Example 22)

The electrical characteristics, heat resistance, and plating characteristics were evaluated using the test specimens prepared in the same manner as in Example 21, except that the feed rates of PEI and PTFE-1 were changed to 45.0 kg/hour and 5.0 kg/hour, respectively.

(Example 23)

The electrical characteristics, heat resistance, and plating characteristics were evaluated using the test specimens prepared in the same manner as in Example 21, except that the feed rates of PEI and PTFE-1 were changed to 40.0 kg/hour and 10.0 kg/hour, respectively.

(Example 24)

The electrical characteristics, heat resistance, and plating characteristics were evaluated using the test specimens prepared in the same manner as in Example 21, except that the feed rates of PEI and PTFE-1 were changed to 35.0 kg/hour and 15.0 kg/hour, respectively. In addition, the flowability of the resin composition before molding was evaluated.

(Example 25)

The electrical characteristics, heat resistance, and plating characteristics were evaluated using the test specimens prepared in the same manner as in Example 21, except that the feed rates of PEI and PTFE-1 were changed to 25.0 kg/hour and 25.0 kg/hour, respectively.

(Example 26)

The electrical characteristics, heat resistance, and plating characteristics were evaluated using the test specimens prepared in the same manner as in Example 21, except that the feed rate of PEI was changed to 40.0 kg/hour, and PFA was used instead of PTFE-1 at a feed rate of 10.0 kg/hour.

(Example 27)

The electrical characteristics, heat resistance, and plating characteristics were evaluated using the test specimens prepared in the same manner as in Example 21, except that the feed rate of PEI was changed to 30.0 kg/hour, and PF-1 was used instead of PTFE-1 at a feed rate of 20.0 kg/hour. In addition, the flowability was evaluated.

(Example 28)

The electrical characteristics, heat resistance, and plating characteristics were evaluated using the test specimens prepared in the same manner as in Example 21, except that the feed rate of PEI was changed to 30.0 kg/hour, and PF-2 was used instead of PTFE-1 at a feed rate of 20.0 kg/hour.

(Example 29)

The electrical characteristics, heat resistance, and plating characteristics were evaluated using the test specimens prepared in the same manner as in Example 21, except that the feed rate of PEI was changed to 30.0 kg/hour, and PF-3 was used instead of PTFE-1 at a feed rate of 20.0 kg/hour.

(Example 30)

The electrical characteristics, heat resistance, and plating characteristics were evaluated using the test specimens prepared in the same manner as in Example 21, except that the feed rate of PEI was changed to 30.0 kg/hour, and PF-4 was used instead of PTFE-1 at a feed rate of 20.0 kg/hour.

(Example 31)

The electrical characteristics, heat resistance, and plating characteristics were evaluated using the test specimens prepared in the same manner as in Example 21, except that the feed rate of PEI was changed to 30.0 kg/hour, and PF-5 was used instead of PTFE-1 at a feed rate of 20.0 kg/hour.

(Example 32)

6kg of PTFE-1 and 20 kg of silica were charged to a V-type mixer and dry blended at 30 rpm and at room temperature for 20 minutes to obtain a preliminary powder mixture. The preliminary powder mixture was fed to a biaxial kneader ("KTX46" manufactured by Kobe Steel Co., Ltd.) for 20 minutes at a rate of 26 kg/hour. The mixture was kneaded at 160 rpm while heating at a barrel setting temperature of 340°C, cooled with water, and extruded from a palletizer while cutting strands to obtain 10 kg of pellets (the material before molding) of the resin composition.

The pellets were dried for three hours in an air circulating oven at 150°C and molded using an injection molding machine ("HB 140" manufactured by Hishiya Steel Manufacturing Co., Ltd.) to obtain test specimens (125 x 13 x 3.1 mm strips and $\phi$100 x 1.6 mm disks) for the evaluation of electrical characteristics, heat resistance, and plating characteristics. The electrical characteristics, heat resistance, and plating characteristics were evaluated using the resulting test specimens.

The components and the amount used for the resin compositions of Examples 1-32 are shown in Table 1. The results of evaluation of the electrical characteristics are shown in Table 2, the results of evaluation of heat resistance and plating characteristic are shown in Table 3, and the results of evaluation of flowability are shown in Table 4.

(Comparative Example 1)

PEI, PTFE-4, and silica were placed in individual quantitative feeders, and PEI and PTFE-4 were fed to a biaxial kneader ("KTX46" manufactured by Kobe Steel Co., Ltd.) for 20 minutes at a rate of 40.0 kg/hour and 10 kg/hour, respectively. The mixture was kneaded at 160 rpm while heating at a barrel setting temperature of 340°C, cooled with water, and extruded from a palletizer while cutting strands to obtain 10 kg of pellets (the material before molding) of the resin composition.

The pellets were dried for three hours in an air circulating oven at 150°C and molded using an injection molding machine ("HB 140" manufactured by Hishiya Steel Manufacturing Co., Ltd.) to obtain test specimens (125 x 13 x 3.1 mm strips and $\phi$100 x 1.6 mm disks) for the evaluation of electrical characteristics, heat resistance, and plating characteristics.

The electrical characteristics, heat resistance, and plating characteristics were evaluated using the resulting test specimens. In addition, the flowability was evaluated.

(Comparative Example 2)

The electrical characteristics, heat resistance, and plating characteristics were evaluated using the molded articles prepared in the same manner as in Comparative Example 1, except that PTFE-5 was used instead of PTFE-4. In addition, the flowability was evaluated.

(Comparative Example 3)

The electrical characteristics, heat resistance, and plating characteristics were evaluated using the molded articles prepared in the same manner as in Comparative Example 1, except that the feed rate of PEI was changed to 49.0 kg/hour, and PTFE-1 was used instead of PTFE-4 at a feed rate of 1.0 kg/hour.

(Comparative Example 4)

The electrical characteristics, heat resistance, and plating characteristics were evaluated using the molded articles prepared in the same manner as in Comparative Example 1, except that the feed rate of PEI was changed to 22.5 kg/hour, and PTFE-1 was used instead of PTFE-4 at a feed rate of 27.5 kg/hour.

The components and the amount used for the resin compositions of Comparative Examples 1-4 are shown in Table 5. The results of evaluation of the electrical characteristics are shown in Table 6, the results of evaluation of heat resistance and plating characteristic are shown in Table 7, and the results of evaluation of flowability are shown in Table 8.

Table 1

| Example | Composition | | |
|---|---|---|---|
| | Resin components (mass% in the total resin component) | | Silica (mass% in the resin composition) |
| 1 | PEI (95) | PTFE-1 (5) | $SiO_2$ (40) |
| 2 | PEI (90) | PTFE-1 (10) | $SiO_2$ (40) |
| 3 | PEI (80) | PTFE-1 (20) | $SiO_2$ (40) |
| 4 | PEI (70) | PTFE-1 (30) | $SiO_2$ (40) |
| 5 | PEI (50) | PTFE-1 (50) | $SiO_2$ (40) |
| 6 | PEI (80) | PTFE-1 (20) | $SiO_2$ (20) |
| 7 | PEI (80) | PTFE-1 (20) | $SiO_2$ (50) |
| 8 | PEI (80) | PTFE-2 (20) | $SiO_2$ (40) |
| 9 | PEI (80) | PTFE-3 (20) | $SiO_2$ (40) |
| 10 | PEI (80) | PFA (20) | $SiO_2$ (40) |
| 11 | PEI (90) | PF-1 (10) | $SiO_2$ (40) |
| 12 | PEI (80) | PF-1 (20) | $SiO_2$ (40) |
| 13 | PEI (60) | PF-1 (40) | $SiO_2$ (40) |
| 14 | PEI (20) | PF-1 (80) | $SiO_2$ (40) |
| 15 | PEI (60) | PF-1 (40) | $SiO_2$ (20) |
| 16 | PEI (60) | PF-1 (40) | $SiO_2$ (60) |
| 17 | PEI (60) | PF-2 (40) | $SiO_2$ (40) |
| 18 | PEI (60) | PF-3 (40) | $SiO_2$ (40) |
| 19 | PEI (60) | PF-4 (40) | $SiO_2$ (40) |
| 20 | PEI (60) | PF-5 (40) | $SiO_2$ (40) |
| 21 | PEI (95) | PTFE-1 (5) | |
| 22 | PEI (90) | PTFE-1 (10) | |
| 23 | PEI (80) | PTFE-1 (20) | |
| 24 | PEI (70) | PTFE-1 (30) | |
| 25 | PEI (50) | PTFE-1 (50) | |
| 26 | PEI (80) | PFA (20) | |
| 27 | PEI (60) | PF-1 (40) | |
| 28 | PEI (60) | PF-2 (40) | |
| 29 | PEI (60) | PF-3 (40) | |
| 30 | PEI (60) | PF-4 (40) | |
| 31 | PEI (60) | PF-5 (40) | |

| 32 | PEI (80) | PTFE-1 (20) | $SiO_2$ (40) |
|---|---|---|---|

Table 2

| Example | Left: Relative dielectric constant εr<br>Right: Dielectric loss tangent tanδ | | |
|---|---|---|---|
| | 1 GHz | 10 GHz | 20 GHz |
| 1 | 3.22 0.0042 | 3.21 0.0042 | 3.21 0.0044 |
| 2 | 3.14 0.0041 | 3.14 0.0042 | 3.14 0.0042 |
| 3 | 3.01 0.0032 | 3.01 0.0034 | 3.00 0.0035 |
| 4 | 2.97 0.0029 | 2.97 0.0031 | 2.97 0.0032 |
| 5 | 2.95 0.0025 | 2.94 0.0025 | 2.94 0.0027 |
| 6 | 2.90 0.0023 | 2.91 0.0026 | 2.90 0.0026 |
| 7 | 3.12 0.0038 | 3.13 0.0041 | 3.12 0.0042 |
| 8 | 3.02 0.0032 | 3.01 0.0034 | 3.01 0.0035 |
| 9 | 3.00 0.0034 | 3.01 0.0036 | 3.00 0.0037 |
| 10 | 2.98 0.0033 | 2.99 0.0035 | 2.98 0.0037 |
| 11 | 3.21 0.0040 | 3.20 0.0043 | 3.20 0.0044 |
| 12 | 3.13 0.0039 | 3.13 0.0041 | 3.12 0.0043 |
| 13 | 3.00 0.0029 | 3.01 0.0031 | 2.99 0.0032 |
| 14 | 2.93 0.0024 | 2.93 0.0025 | 2.92 0.0028 |
| 15 | 2.88 0.0022 | 2.89 0.0025 | 2.89 0.0025 |
| 16 | 3.25 0.0041 | 3.26 0.0043 | 3.26 0.0047 |
| 17 | 3.03 0.0033 | 3.03 0.0034 | 3.02 0.0036 |
| 18 | 3.02 0.0030 | 3.02 0.0033 | 3.01 0.0037 |
| 19 | 3.04 0.0029 | 3.03 0.0033 | 3.02 0.0035 |
| 20 | 2.94 0.0027 | 2.95 0.0029 | 2.95 0.0030 |
| 21 | 3.01 0.0022 | 3.01 0.0025 | 3.01 0.0024 |
| 22 | 2.98 0.0022 | 2.97 0.0023 | 2.95 0.0023 |
| 23 | 2.89 0.0020 | 2.90 0.0020 | 2.90 0.0021 |
| 24 | 2.87 0.0020 | 2.88 0.0019 | 2.87 0.0020 |
| 25 | 2.79 0.0018 | 2.78 0.0019 | 2.78 0.0019 |
| 26 | 2.88 0.0023 | 2.89 0.0025 | 2.87 0.0025 |
| 27 | 2.78 0.0019 | 2.77 0.0019 | 2.79 0.0020 |
| 28 | 2.78 0.0018 | 2.79 0.0018 | 2.77 0.0019 |
| 29 | 2.79 0.0020 | 2.79 0.0019 | 2.79 0.0019 |
| 30 | 2.98 0.0022 | 2.98 0.0022 | 2.96 0.0023 |
| 31 | 2.85 0.0018 | 2.86 0.0018 | 2.86 0.0019 |
| 32 | 3.01 0.0033 | 3.00 0.0034 | 3.00 0.0034 |

Table 3

| Example | Plating film adhesion properties | | Heat resistance | | |
|---|---|---|---|---|---|
| | Swelling | Cross-cut test | Distorsion | Swelling | Peeling |
| 1 | ○ | ○ | ○ | ○ | ○ |
| 2 | ○ | ○ | ○ | ○ | ○ |
| 3 | ○ | ◎ | ○ | ○ | ○ |
| 4 | ○ | ◎ | ○ | ○ | ○ |
| 5 | ○ | ○ | ○ | ○ | ○ |
| 6 | ○ | ◎ | ○ | ○ | ○ |
| 7 | ○ | ◎ | ○ | ○ | ○ |
| 8 | ○ | ◎ | ○ | ○ | ○ |
| 9 | ○ | ◎ | ○ | ○ | ○ |
| 10 | ○ | ◎ | ○ | ○ | ○ |
| 11 | ○ | ◎ | ○ | ○ | ○ |
| 12 | ◎ | ◎ | ○ | ○ | ○ |
| 13 | ◎ | ◎ | ○ | ○ | ○ |
| 14 | ◎ | ◎ | ○ | ○ | ○ |
| 15 | ◎ | ◎ | ○ | ○ | ○ |
| 16 | ◎ | ◎ | ○ | ○ | ○ |
| 17 | ◎ | ◎ | ○ | ○ | ○ |
| 18 | ◎ | ◎ | ○ | ○ | ○ |
| 19 | ◎ | ◎ | ○ | ○ | ○ |
| 20 | ◎ | ◎ | ○ | ○ | ○ |
| 21 | ○ | ○ | ○ | ○ | ○ |
| 22 | ○ | ○ | ○ | ○ | ○ |
| 23 | ○ | ○ | ○ | ○ | ○ |
| 24 | ○ | ○ | ○ | ○ | ○ |
| 25 | ○ | ○ | ○ | ○ | ○ |
| 26 | ○ | ○ | ○ | ○ | ○ |
| 27 | ○ | ○ | ○ | ○ | ○ |
| 28 | ○ | ○ | ○ | ○ | ○ |
| 29 | ○ | ○ | ○ | ○ | ○ |
| 30 | ○ | ○ | ○ | ○ | ○ |
| 31 | ○ | ○ | ○ | ○ | ○ |
| 32 | ◎ | ◎ | ○ | ○ | ○ |

Table 4

| Example | MFR(g/10 minutes) | | | |
|---|---|---|---|---|
| | 340℃ | 350℃ | 360℃ | 370℃ |
| 3 | 28.3 | 40.7 | 50.1 | 78.3 |
| 4 | 29.9 | 42.3 | 57.0 | 85.6 |
| 12 | 30.3 | 44.5 | 59.6 | 90.7 |
| 13 | 43.9 | 54.4 | 83.9 | 94.6 |
| 14 | 47.7 | 61.6 | 87.4 | 99.8 |
| 24 | 31.0 | 45.9 | 61.2 | 93.5 |
| 27 | 49.8 | 73.5 | 97.9 | 108.2 |

Table 5

| Comparative Example | Composition | | |
|---|---|---|---|
| | Resin components (mass% in the total resin component) | | Silica (mass% in the resin composition) |
| 1 | PEI (80) | PTFE-4 (20) | - - |
| 2 | PEI (80) | PTFE-5 (20) | - - |
| 3 | PEI (98) | PTFE-1 (2) | - - |
| 4 | PEI (45) | PTFE-1 (55) | - - |

Table 6

| Comparative Example | Left: Relative dielectric constant εr<br>Right: Dielectric loss tangent tanδ | | | | | |
|---|---|---|---|---|---|---|
| | 1 GHz | | 10 GHz | | 20 GHz | |
| 1 | 3.02 | 0.0032 | 3.01 | 0.0033 | 3.00 | 0.0034 |
| 2 | 3.04 | 0.0031 | 3.02 | 0.0032 | 3.00 | 0.0033 |
| 3 | 3.51 | 0.0052 | 3.51 | 0.0054 | 3.50 | 0.0058 |
| 4 | 2.76 | 0.0020 | 2.77 | 0.0019 | 2.76 | 0.0018 |

Table 7

| Comparative Example | Plating film adhesion properties | | Heat resistance | | |
|---|---|---|---|---|---|
| | Swelling | Cross-cut test | Distortion | Swelling | Peeling |
| 1 | △ | × | ○ | △ | × |
| 2 | × | × | ○ | × | × |
| 3 | ○ | ○ | ○ | ○ | ○ |
| 4 | × | × | △ | × | × |

Table 8

| Comparative Example | MFR(g/10 minutes) | | | |
|---|---|---|---|---|
| | 340°C | 350°C | 360°C | 370°C |
| 1 | 13.6 | 15.2 | 20.5 | 36.8 |
| 2 | 10.2 | 11.0 | 18.7 | 35.7 |
| PEI | 16.2 | 22.2 | 32.8 | 43.1 |

The following remarks apply to the results of the above Examples and Comparative Examples.

A clear increase in MFR was seen by the addition of fluororesin particles.

The results of Examples 12, 13, and 14 indicate that the greater the amount of fluororesin particles, the greater the value of MFR.

The results of Examples 3, 4, 13, and 14 indicate that the resin composition exhibits an MFR higher than that of PEI which is the base resin in spite of the addition of silica.

The compositions of Comparative Examples 1 and 2 in which fluororesin particles with a large diameter were used exhibited not only the bad results shown in Tables, but also a MFR lower than the base resin PEI. As can be seen from these results, the MFR is impaired if fluororesin pellets (or fluororesin with a large particle size) are used. By contrast, the MFR is improved if fluororesin is added in the form of fine particles.

All resin compositions shown in Examples 1-31 exhibit excellent plating film adhesion.

In the heat resistance test carried out at 240°C,the molded articles did not show distortion, swelling of plating film, or peeling.

On the other hand, the resin compositions of Comparative Examples 1 and 2 differ from the resin compositions of Examples in the use of polytetrafluoroethylene with a large size. Specifically, polytetrafluoroethylene pellets (PFTE-4) were used in Comparative Example 1, whereas polytetrafluoroethylene particles (PFTE-5) with an average particle size of 330 μm were used in Comparative Example 2. Both the resin compositions had plating films with swelling, exhibited a large number of peeled square pieces in the cross-cut test, and exhibited unacceptably low adhesion of plating films.

From the comparison of the results obtained in Examples 3, 4, 12, 13, 14, 24, 27, Comparative Examples 1, 2, and the base polyether imide resin (PEI), the addition of fluororesin particles was proven to increase the value of MFR.

The results of Examples 3, 4, 12, 13, and 14 indicate that the resin compositions exhibited an MFR higher than that of PEI in spite of the addition of silica.

The resin compositions of Comparative Examples 1-2 using a large particles had MFR values lower than the base PEI resin. As can be seen from these results, the MFR is impaired if fluororesin pellets with a large size are used. By contrast, the MFR is improved if fluororesin is added in the form of fine particles.

The resin compositions of Examples 21-25 and Comparative Example 3 are common in the use of the raw material PFTE-1, but differ in the amount of PFTE-1 added. The composition of Comparative Example 3 containing only a small amount of PFTE-1 exhibited impaired electrical characteristics, although the composition had no problem in the plating film adhesion and heat resistance.

The resin composition of Comparative Example 4 is also the same as these compositions inasmuch as the raw material PFTE-1 is used, but the mount of PFTE-1 added is different. The composition of Comparative Example 4 containing a large amount of PFTE-1 exhibited unduly impaired plating film adhesion, although the composition had no problem in the electrical characteristics.

In Example 32, PFTE-1 and silica were dry blended to prepare a preliminary powder mixture, and then the preliminary powder mixture was blended with PEI. Thus, preparation of preliminary powder mixture differentiates the Example 32 from Example 3 in which no preliminary mixture is prepared. As a result, the resin composition of Example 32 showed better plating film adherence, although the electrical characteristics and heat resistance were equivalent.

## INDUSTRIAL APPLICABILITY

As described above, the present invention is useful for forming electronic parts with a three-dimensional configuration which are molded by injection molding, particularly surface mount parts used in the high frequency region, for example, three-dimensional circuit parts, three-dimensional circuit boards, injection molded interconnection devices (MID), and injection molded circuit boards (MCB).

## Claims

1. A resin composition obtained by mixing 4-52 mass% of fluororesin particles with an average particle diameter of 0.01-300 μm and 48-96 mass% of polyether imide shown by the following formula (2),

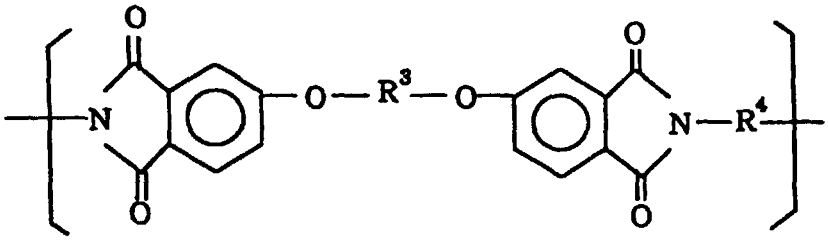

(2)

wherein $R^3$ is a divalent aromatic group having 6-30 carbon atoms, and $R^4$ is a divalent aromatic group having 6-20 carbon atoms, an alkylene group, or a cycloalkylene group.

2. The resin composition according to claim 1, wherein the operation of mixing the fluororesin particles and the polyether imide comprises preliminary mixing of the fluororesin particles and a portion of the polyether imide and mixing the resulting preliminary mixture and the remaining portion of the polyether imide.

3. The resin composition according to claim 2, wherein the preliminary mixture comprises 15-85 mass% of the polyether imide and 85-15 mass% of fluororesin particles.

4. The resin composition according to claim 2 or claim 3, wherein the preliminary mixture has an average particle diameter of 0.1-500 μm.

5. The resin composition according to any one of claims 1 to 4, obtained by further mixing silica having an $SiO_2$ structure, a purity of 96% or more, a spherical or amorphous configuration with a particle shape of an aspect ratio of 10 or less, and an average particle diameter of 0.1-100 μm, in an amount of 5-70 mass% for 100 mass% of the fluororesin particles, polyether imide and silica.

6. A resin composition comprising 4-52 mass% of fluororesin particles with an average particle diameter 0.01-300 μm, 48-96 mass% of polyether imide shown by the following formula (2), and 5-70 mass% (for 100 mass% of the fluororesin particles , polyether imide and silica) of silica having an $SiO_2$ structure, a purity of 96% or more, a spherical or amorphous configuration with a particle shape of an aspect ratio of 10 or less, and an average particle diameter of 0.1-100 μm,

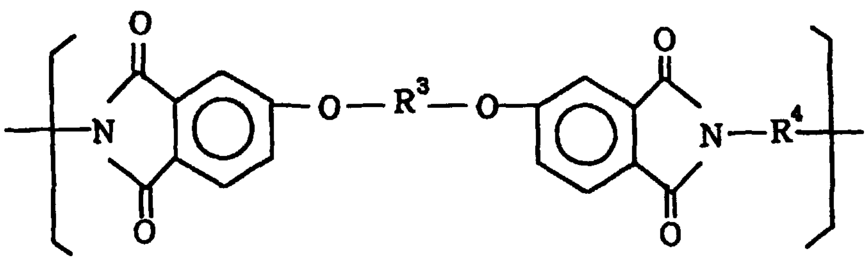

(2)

wherein $R^3$ is a divalent aromatic group having 6-30 carbon atoms, and $R^4$ is a divalent aromatic group having 6-20 carbon atoms, an alkylene group, or a cycloalkylene group.

7. The resin composition according to claim 6, obtained by mixing the fluororesin particles and silica to obtain a preliminary mixture, and then mixing the resulting preliminary mixture and the polyether imide.

8. The resin composition according to any one of claims 1-7, wherein the polyether imide has the following formula

(3).

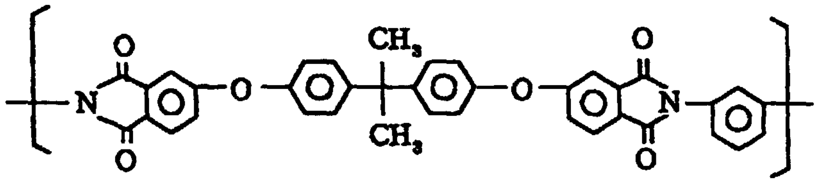

(3)

9. The resin composition according to any one of claims 1-8, wherein the polyether imide having the formula (2) or (3) has a number average molecular weight of 3,000-5,000,000.

10. The resin composition according to any one of claims 1-9 which can be formed into a molded product having a relative dielectric constant of 3.5 or less and a dielectric loss tangent of 0.01 or less in a high frequency region of 1 GHz or more.

11. A molded product made from the resin composition according to any one of claims 1 to 10.

12. The molded product of claims 11 having a relative dielectric constant of 3.5 or less and a dielectric loss tangent of 0.01 or less in a high frequency region of 1 GHz or more.

13. A process for producing the resin composition according to any one of claims 1-10 comprising: dissolving the polyether imide in chloroform to a concentration of 10-500 g/L, dispersing the fluororesin particles in the resulting solution in an amount so that the ratio of the polyether imide and the fluororesin particles is in the range from 15:85 to 85:15 mass%, evaporating the solvent to obtain a preliminary mixture with an average particles diameter of 0.1-500 µm, further adding the polyether imide, and blending the mixture.

14. A process for producing the resin composition according to claim 7 comprising: mixing 1 mass% of the polyether imide and 1-10 mass% of the silica under dry conditions at a temperature above the melting point of the resin to obtain a preliminary mixture, and adding the polyether imide to the preliminary mixture, and blending the mixture.

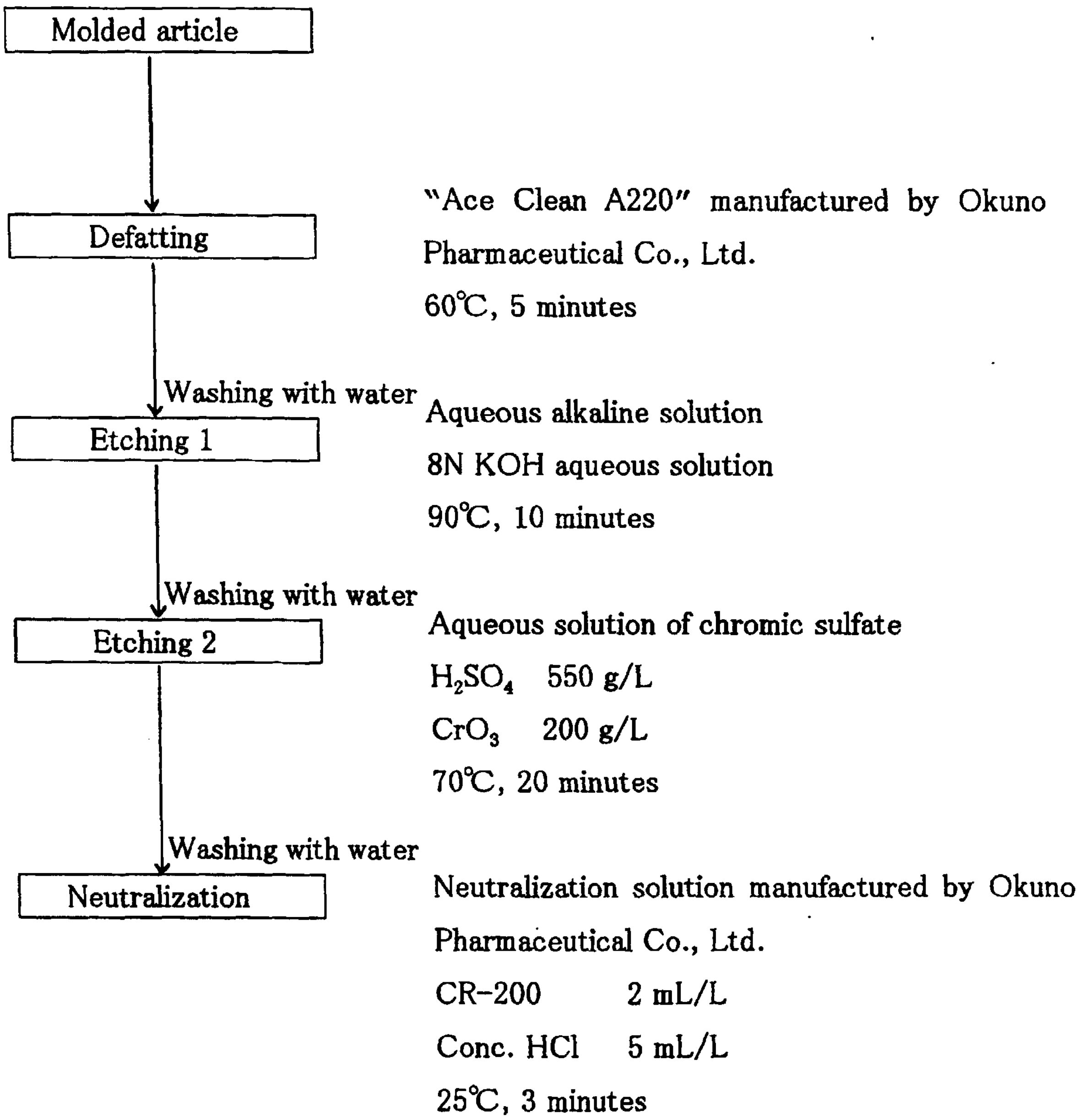
Molded article
Defatting
"Ace Clean A220" manufactured by Okuno Pharmaceutical Co., Ltd.
60℃, 5 minutes
Washing with water
Etching 1
Aqueous alkaline solution
8N KOH aqueous solution
90℃, 10 minutes
Washing with water
Etching 2
Aqueous solution of chromic sulfate
$H_2SO_4$ 550 g/L
$CrO_3$ 200 g/L
70℃, 20 minutes
Washing with water
Neutralization
Neutralization solution manufactured by Okuno Pharmaceutical Co., Ltd.
CR-200 2 mL/L
Conc. HCl 5 mL/L
25℃, 3 minutes

Fig.1

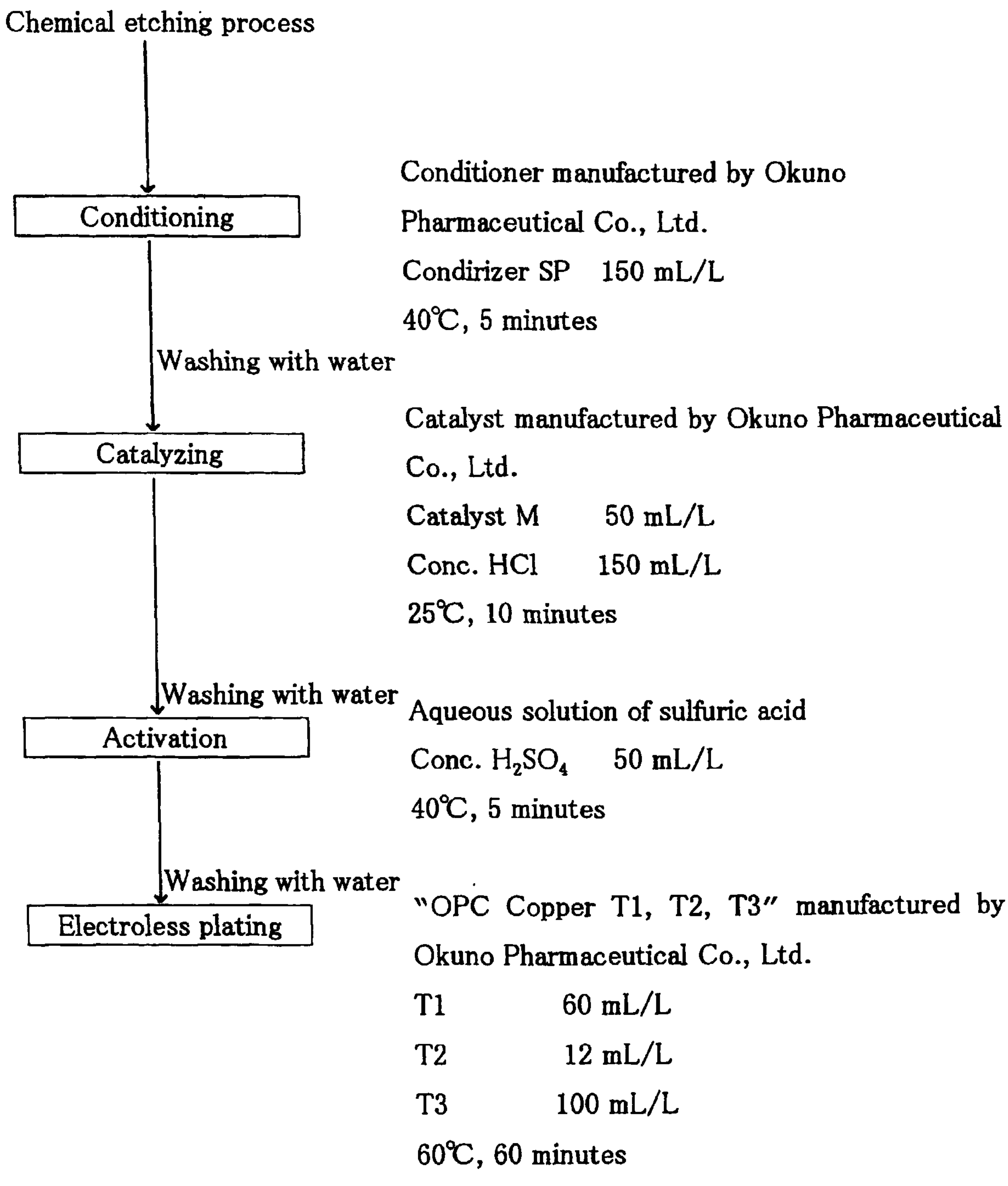
Chemical etching process
Conditioning
Conditioner manufactured by Okuno Pharmaceutical Co., Ltd.
Condirizer SP 150 mL/L
40℃, 5 minutes
Washing with water
Catalyzing
Catalyst manufactured by Okuno Pharmaceutical Co., Ltd.
Catalyst M 50 mL/L
Conc. HCl 150 mL/L
25℃, 10 minutes
Washing with water
Activation
Aqueous solution of sulfuric acid
Conc. $H_2SO_4$ 50 mL/L
40℃, 5 minutes
Washing with water
Electroless plating
"OPC Copper T1, T2, T3" manufactured by Okuno Pharmaceutical Co., Ltd.
T1 60 mL/L
T2 12 mL/L
T3 100 mL/L
60℃, 60 minutes

Fig.2

## INTERNATIONAL SEARCH REPORT

International application No.
PCT/JP99/00544

A. CLASSIFICATION OF SUBJECT MATTER
Int.Cl$^6$ C08L79/08, C08L27/18, C08K3/36

According to International Patent Classification (IPC) or to both national classification and IPC

B. FIELDS SEARCHED

Minimum documentation searched (classification system followed by classification symbols)
Int.Cl$^6$ C08L79/08, C08L27/12-27/20, C08K3/00-3/40

Documentation searched other than minimum documentation to the extent that such documents are included in the fields searched

Electronic data base consulted during the international search (name of data base and, where practicable, search terms used)
CA (STN), REGISTRY (STN)

C. DOCUMENTS CONSIDERED TO BE RELEVANT

| Category* | Citation of document, with indication, where appropriate, of the relevant passages | Relevant to claim No. |
|---|---|---|
| X<br><br>Y<br>A | JP, 8-259765, A (NTN Corp.),<br>8 October, 1996 (08. 10. 96)<br>& US, 5726232, A | 1, 3, 8-9, 11<br><br>5-7<br>2, 4, 10, 12-14 |
| Y<br>A | JP, 62-149437, A (Sumitomo Bakelite Co., Ltd.),<br>3 July, 1987 (03. 07. 87) (Family: none) | 5-7<br>1-4, 8-14 |
| A | JP, 2-156655, A (Hitachi,Ltd.),<br>15 June, 1990 (15. 06. 90) (Family: none) | 1-14 |
| A | JP, 4-280659, A (Nitto Denko Corp.),<br>6 October, 1992 (06. 10. 92) (Family: none) | 1-14 |
| A | JP, 3-91556, A (Lion Corp.),<br>17 April, 1991 (17. 04. 91) (Family: none) | 1-14 |

☐ Further documents are listed in the continuation of Box C. ☐ See patent family annex.

* Special categories of cited documents:
"A" document defining the general state of the art which is not considered to be of particular relevance
"E" earlier document but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 15 April, 1999 (15. 04. 99) | 27 April, 1999 (27. 04. 99) |
| Name and mailing address of the ISA/<br>Japanese Patent Office | Authorized officer |
| Facsimile No. | Telephone No. |

Form PCT/ISA/210 (second sheet) (July 1992)